# EUROPEAN PATENT APPLICATION

(11) **EP 2 105 968 A1**
(43) Date of publication of application: **30.09.2009**
(21) Application number: 08103038.9
(22) Date of filing: 27.03.2008
(51) Int. Cl.: H01L 31/0216, H01L 31/055

(54) **Method for making a full-spectrum solar cell with an anti-reflection layer doped with silicon quantum dots**

(71) Applicant: Atomic Energy Council - Institute of Nuclear Energy Research, 333 Taoyuan (TW)
(72) Inventor: Yang, Tsun-Neng, 115, Taipei City (TW)
(74) Representative: Lang, Christian

(57) **Abstract**

In a method for making a full-spectrum solar cell, there is provided an ordinary solar cell with an anti-reflection layer. The anti-reflection layer is coated with a film of silicon nitride and/or silicon oxide. The silicon/nitrogen ratio and/or the silicon/oxygen ratio and the temperature are regulated, thus forming a silicon-rich film via doping the anti-reflection layer with silicon from the film of silicon nitride and/or silicon oxide. The precipitation of the silicon in the silicon-rich film is executed based on a mechanism of phase separation, thus forming silicon quantum dots of various sizes in the anti-reflection layer.

## Description

### BACKGROUND OF INVENTION

### 1. FIELD OF INVENTION

The present invention relates to a method for making a full-spectrum solar cell and, more particularly, to a method for making a full-spectrum solar cell with an anti-reflection layer doped with silicon quantum dots.

### 2. RELATED PRIOR ART

Conventional crystalline silicon solar cells and thin-film silicon-based solar cells include III-V group compound solar cells and II-VI group compound solar cells. Such a solar cell includes an anti-reflection layer. To make such the anti-reflection layer of a thin-film silicon-based solar cell, silicon nitride and/or silicon oxide are used. The silicon nitride is generally Si₃N₄ while the silicon oxide is SiO₂. The band gap of such a silicon-based material is about 1.1 to 1.2 eV. The portion of the energy of photons higher than the band gap will become heat that would damage the solar cell. Moreover, the penetration depth of the photons is small so that electron-hole pairs caused by the photons would easily be captured by superficial defects, not effectively used.

The present invention is therefore intended to obviate or at least alleviate the problems encountered in prior art.

### SUMMARY OF INVENTION

It is an objective of the present invention to provide a method for making a full-spectrum solar cell with an anti-reflection layer doped with silicon quantum dots

It is another objective of the present invention to provide a brief and inexpensive method for making a full-spectrum solar cell.

In a method for making a full-spectrum solar cell according to the present invention, there is provided an ordinary solar cell with an anti-reflection layer. The anti-reflection layer is coated with a film of silicon nitride and/or silicon oxide. The silicon/nitrogen ratio and/or the silicon/oxygen ratio and the temperature are regulated, thus forming a silicon-rich film via doping the anti-reflection layer with silicon from the film of silicon nitride and/or silicon oxide. The precipitation of the silicon in the silicon-rich film is executed based on a mechanism of phase separation, thus forming silicon quantum dots of various sizes in the anti-reflection layer.

Other objectives, advantages and features of the present invention will be apparent from the following description referring to the attached drawings.

### BRIEF DESCRIPTION OF DRAWINGS

The present invention will be described via the detailed illustration of three embodiments referring to the drawings.
Fig. 1 is a flow chart of a method for making a solar cell with an anti-reflection layer doped with silicon quantum dots according to the first embodiment of the present invention.
Fig. 2 is a cross-sectional view of a conventional solar cell to be processed according to the method shown in Fig. 1.
Fig. 3 is a cross-sectional view of a solar cell with an anti-reflection layer doped with silicon quantum dots transformed from the conventional solar cell shown in Fig. 2 according to the method shown in Fig. 1.
Fig. 4 shows the operation of the solar cell shown in Fig. 3.
Fig. 5 is a cross-sectional view of another conventional solar cell to be processed in a method for making a solar cell with an anti-reflection layer doped with silicon quantum dots according to the second embodiment of the present invention.
Fig. 6 is a cross-sectional view of a solar cell with an anti-reflection layer doped with silicon quantum dots transformed from the conventional solar cell shown in Fig. 5.
Fig. 7 shows the operation of the solar cell shown in Fig. 6.
Fig. 8 is a cross-sectional view of another conventional solar cell to be processed in a method for making a solar cell with an anti-reflection layer doped with silicon quantum dots according to the third embodiment of the present invention.
Fig. 9 is a cross-sectional view of a solar cell with an anti-reflection layer doped with silicon quantum dots transformed from the conventional solar cell shown in Fig. 8.
Fig. 10 shows the operation of the solar cell shown in Fig. 9.

### DETAILED DESCRIPTION OF EMBODIMENTS

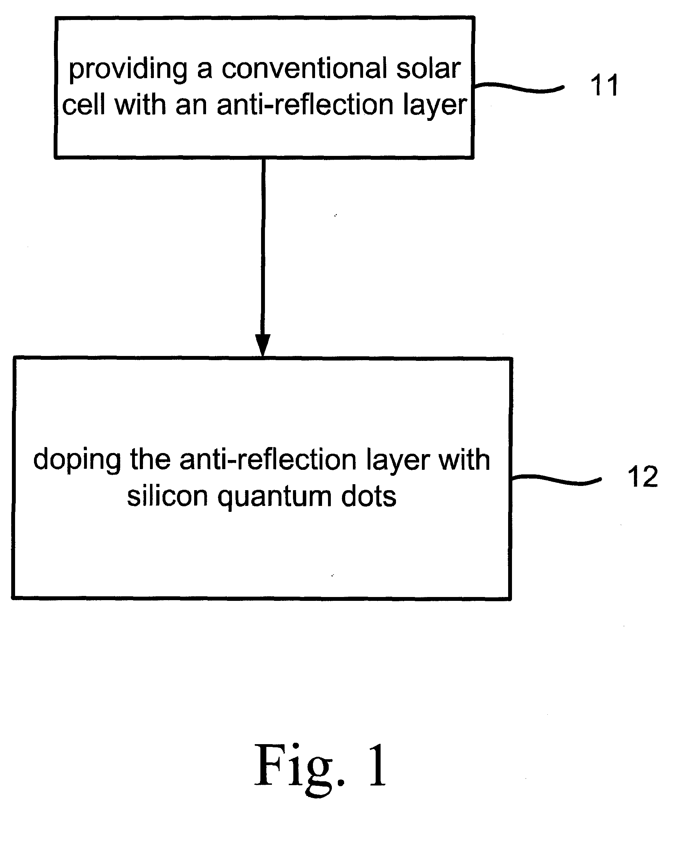

Referring to Fig. 1, there is shown a method for making a solar cell with an anti-reflection layer doped with silicon quantum dots according to the present invention. At 11, a conventional solar cell is provided. The conventional solar cell may be a single-crystal silicon solar cell, a multi-crystal silicon solar cell, a thin-film silicon-based solar cell, a III-V group compound solar cell, a II-VI group compound solar cell or any other proper solar cell. At 12, the conventional solar cell is transformed into a solar cell including an anti-reflection layer doped with silicon quantum dots.

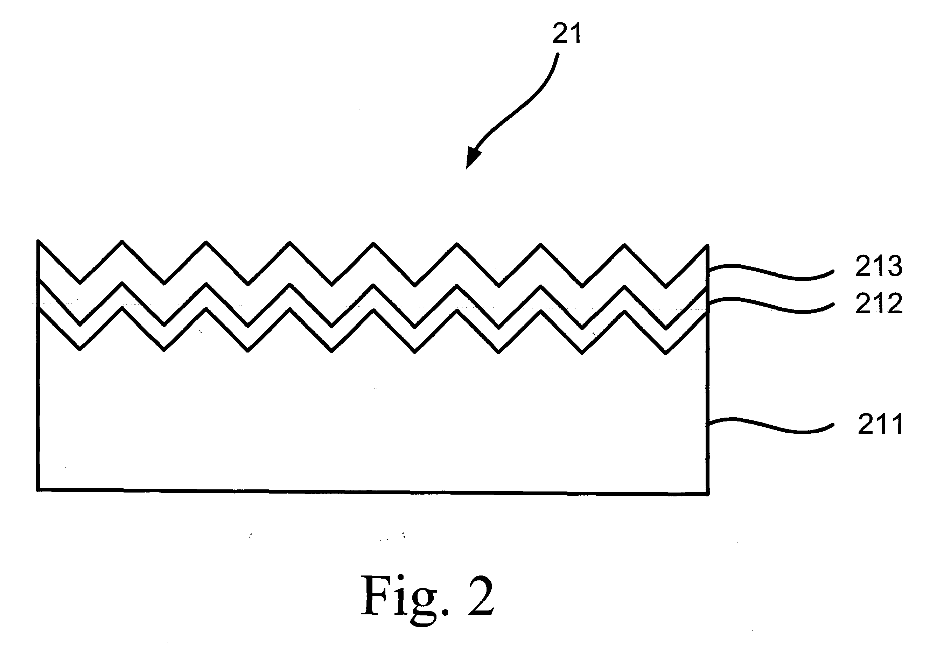

Referring to Figs. 1 and 2, at 11, a single-crystal solar cell 21 is provided according to a first embodiment of the present invention. The single-crystal solar cell 21 includes a p-type substrate 211, an n-type diffusion layer 212 and an anti-reflection layer 213.

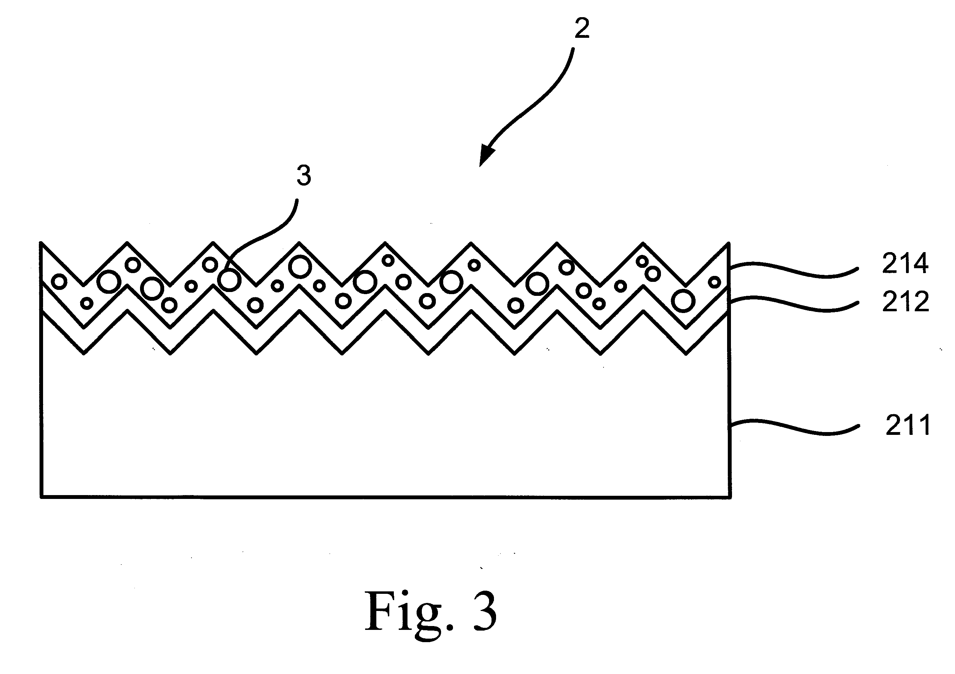

Referring to Figs. 1 and 3, at 12, the anti-reflection layer 213 is transformed into an anti-reflection layer 214 doped with silicon quantum dots 3 based on a physical or chemical method. Such a method is plasma-enhanced chemical vapor deposition, electron cyclotron resonance chemical vapor deposition, very high frequency chemical vapor deposition, hot wire chemical vapor deposition, e-gun or sputtering for example.

At first, the anti-reflection layer 213 is coated with a film of silicon nitride and/or silicon oxide. To this end, silicon hydride and dichlorosilane are used as a source of silicon, and nitrogen and ammonia are used as a source of nitrogen, and oxygen and nitrous oxide are used as a source of oxygen. The silicon/nitrogen ratio is higher than 3:4 while the silicon/oxygen ratio is higher than 1:2. During the forming of the film, the temperature is 100 to 400 degrees Celsius. In a stable status at a low temperature, the silicon nitride exists in the form of Si₃N₄ while the silicon oxide exists in the form of SiO₂.

Then, silicon is transferred into the anti-reflection layer 213 from the film of silicon nitride and/or silicon oxide. The anti-reflection layer 213 dosed with the silicon is called the "silicon-rich film".

Finally, the silicon-rich film is processed based on a mechanism of phase separation such as an annealing process at 500 to 900 degrees Celsius. Thus, the precipitation of the silicon in the silicon-rich film is executed so that the silicon becomes the silicon quantum dots of 1 to 10 nm in the anti-reflection layer 213. The anti-reflection layer 213 is transformed into the anti-reflection layer 214 doped with the silicon quantum dots 3 of 1 to 10 nm. That is, the conventional solar cell 21 is transformed into a full-spectrum solar cell 2 including the anti-reflection layer 214 doped with the silicon quantum dots 3.

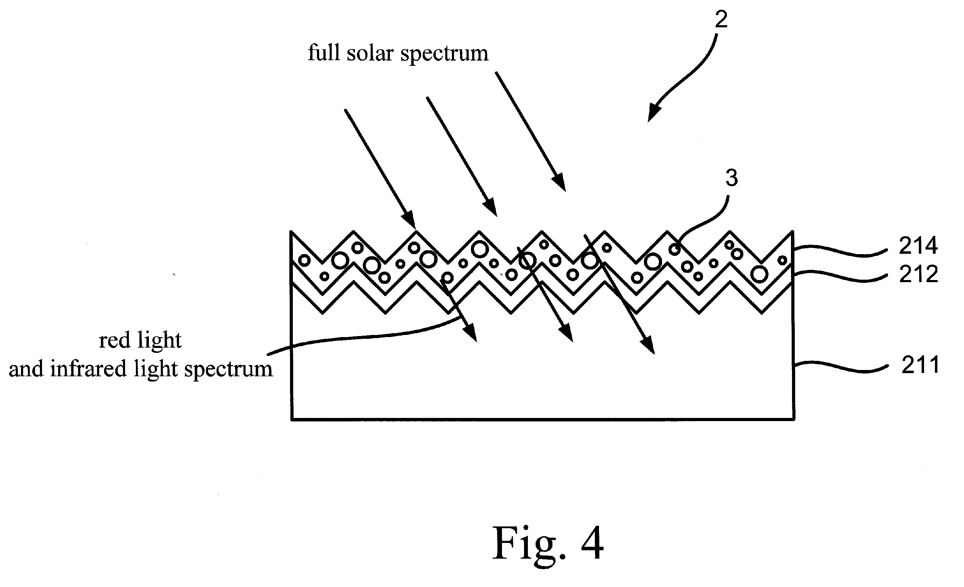

Referring to Fig. 4, the operation of the full-spectrum solar cell 2 is shown. Based on the quantum confinement effect, independent band gaps of 1.0 eV, 1.1 eV, 1.2 eV, ... 4.0 eV, ... exist in the anti-reflection layer 214 doped with the silicon quantum dots 3 of 1 to 10 nm. Via the structure of the band gaps of the quantification, light of higher energy levels such as the violet and ultra-violet light is transformed into light of lower energy levels such as the red and infra-red light. The light of the lower energy levels is used to produce electron-hole pairs. The electron-hole pairs are far from superficial defects and can effectively be absorbed by the full-spectrum solar cell 2. Therefore, the efficiency of the conversion of sunlit into electricity by the full-spectrum solar cell 2 is very high.

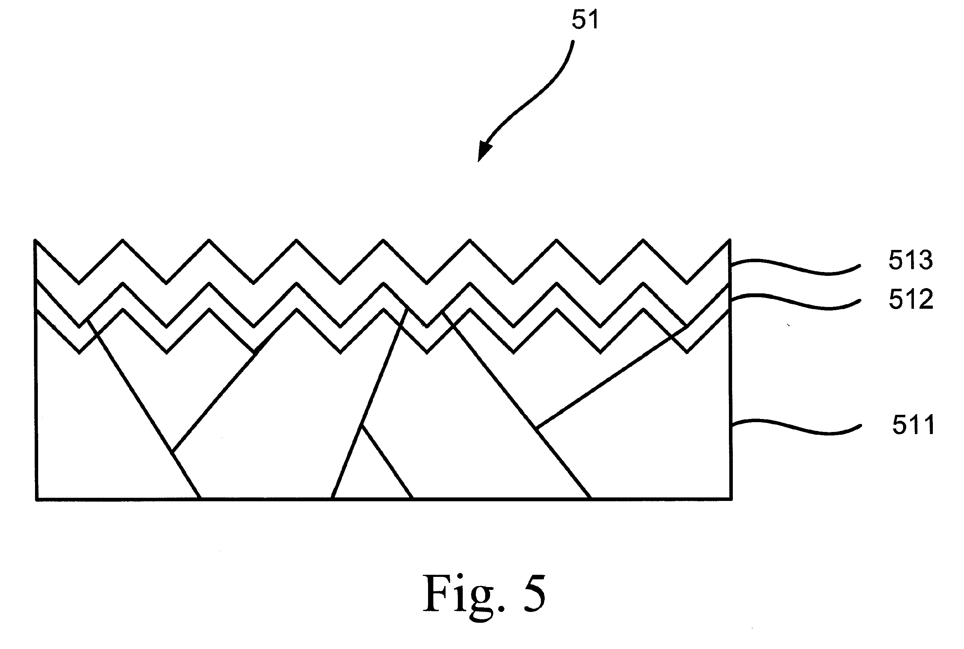

Referring to Fig. 5, according to a second embodiment of the present invention, there is provided a multi-crystal silicon solar cell 51 as the conventional solar cell. The multi-crystal silicon solar cell 51 includes a p-type substrate 511, an n-type diffusion layer 512 and an anti-reflection layer 513.

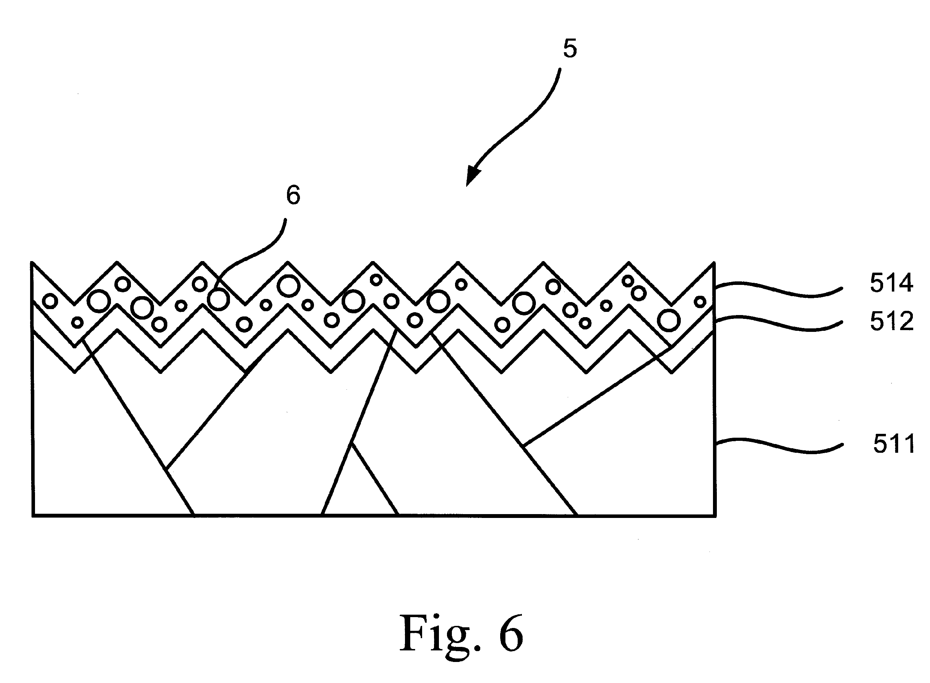

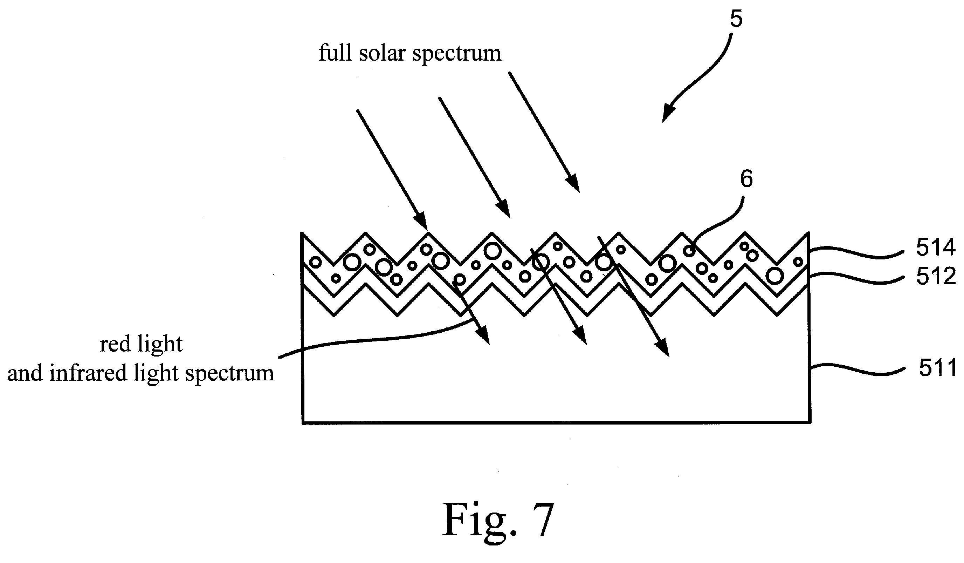

Referring to Figs. 6 and 7, the anti-reflection layer 513 is transformed into an anti-reflection layer 514 doped with silicon quantum dots 6 later. For the transformation, the silicon/nitrogen ratio is higher than 3:4 while the silicon/oxygen ratio is higher than 1:2. The multi-crystal silicon solar cell 51 is transformed into a full-spectrum solar cell 5 including the anti-reflection layer 513 doped with the silicon quantum dots 6.

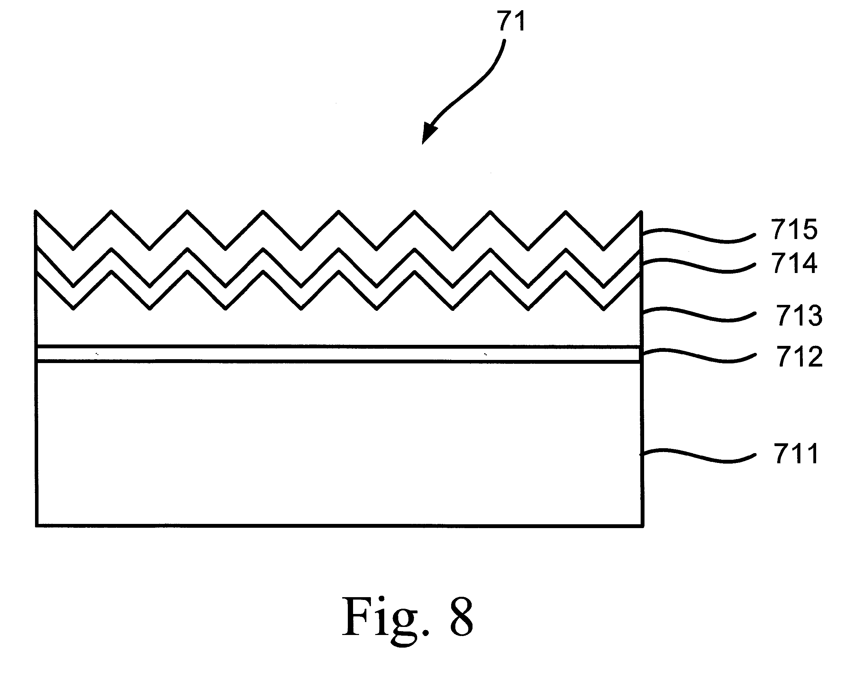

Referring to Fig. 8, according to a third embodiment of the present invention, there is provided a thin-film silicon-based solar cell 71 as the conventional solar cell. The thin-film silicon-based solar cell 71 includes a substrate 711, a p-type layer 712, an i-type layer 713, an n-type layer 714 and an anti-reflection layer 715.

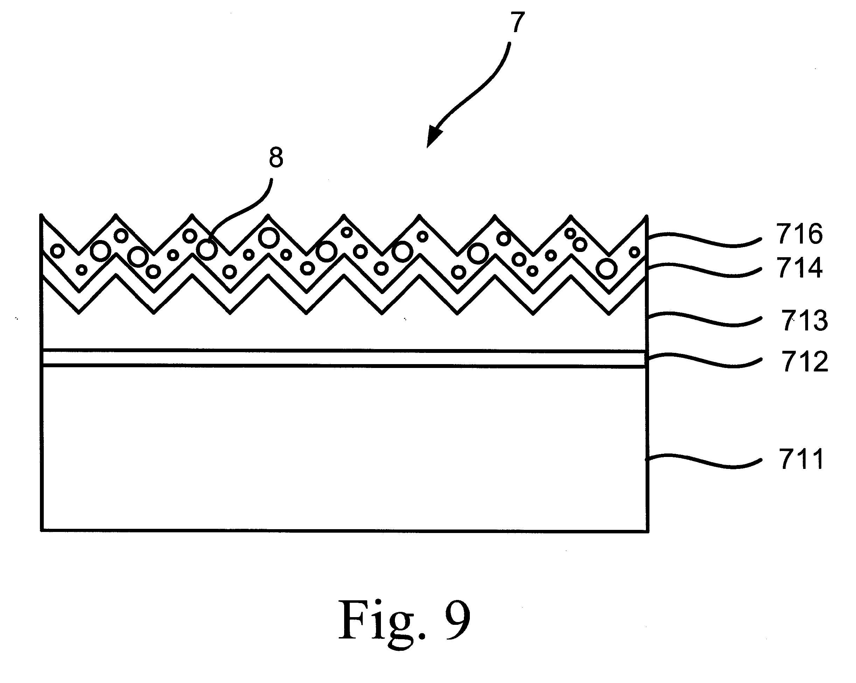

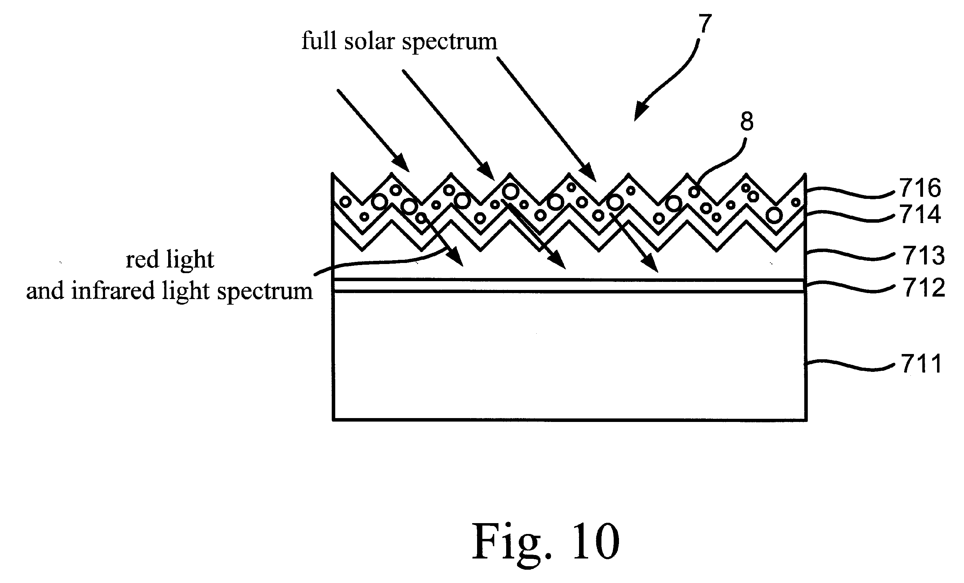

Referring to Figs. 9 and 10, the anti-reflection layer 715 is transformed into an anti-reflection layer 716 doped with silicon quantum dots 8. For the transformation, the silicon/nitrogen ratio is higher than 3:4 while the silicon/oxygen ratio is higher than 1:2. The thin-film silicon-based solar cell 71 is transformed into a full-spectrum solar cell 7 including the anti-reflection layer 716 doped with the silicon quantum dots 8.

The present invention has been described via the detailed illustration of the embodiments. Those skilled in the art can derive variations from the embodiments without departing from the scope of the present invention. Therefore, the embodiments shall not limit the scope of the present invention defined in the claims.

## Claims

1. A method for making a full-spectrum solar cell comprising the steps of:
providing an ordinary solar cell with an anti-reflection layer;
coating the anti-reflection layer with a film of at least one of silicon nitride and silicon oxide;
regulating at least one of the silicon/nitrogen ratio and the silicon/oxygen ratio and the temperature, thus forming a silicon-rich film via doping the anti-reflection layer with silicon from the film of at least one of silicon nitride and silicon oxide; and
precipitating the silicon in the silicon-rich film based on a mechanism of phase separation, thus forming silicon quantum dots of various sizes in the anti-reflection layer.

2. The method according to claim 1, wherein the solar cell is selected from a group consisting of a single-crystal silicon solar cell, a multi-crystal silicon solar cell, a thin-film silicon-based solar cell, a III-V group compound solar cell and a II-VI group compound solar cell.

3. The method according to claim 1, wherein the anti-reflection layer is doped with the silicon quantum dots based on a process selected from a group consisting of plasma-enhanced chemical vapor deposition, electron cyclotron resonance chemical vapor deposition, very high frequency chemical vapor deposition, hot wire chemical vapor deposition, e-gun and sputtering.

4. The method according to claim 1, wherein silicon hydride and dichlorosilane are used as a source of silicon for the film.

5. The method according to claim 1, wherein nitrogen and ammonia are used as a source of nitrogen for the film.

6. The method according to claim 1, wherein oxygen and nitrous oxide are used as a source of oxygen for the film.

7. The method according to claim 1, wherein the silicon/nitrogen ratio is higher than 3:4.

8. The method according to claim 1, wherein the silicon/oxygen ratio is higher than 1:2.

9. The method according to claim 1, wherein the temperature is 100 to 400 degrees Celsius.

10. The method according to claim 1, wherein the annealing process is executed at 500 to 900 degrees Celsius.

11. The method according to claim 1, wherein the silicon nitride exists in the form of Si₃N₄.

12. The method according to claim 1, wherein the silicon oxide exists in the form of SiO₂.

13. The method according to claim 1, wherein the sizes of the silicon quantum dots are 1 to 10 nm.
